# EUROPEAN PATENT SPECIFICATION

(11) **EP 4 033 662 B1**
(45) Date of publication and mention of the grant of the patent: **10.01.2024**
(21) Application number: 21870482.3
(22) Date of filing: 08.07.2021
(51) Int. Cl.: H03K 5/156, G11C 7/22, G11C 29/02, H03K 5/135

(54) **CALIBRATION CIRCUIT, MEMORY, AND CALIBRATION METHOD**
KALIBRIERUNGSSCHALTUNG, SPEICHER UND KALIBRIERUNGSVERFAHREN
CIRCUIT D'ÉTALONNAGE, MÉMOIRE, ET PROCÉDÉ D'ÉTALONNAGE

(30) Priority: 28.10.2020 CN 202011173755
(43) Date of publication of application: 27.07.2022
(73) Proprietor: Changxin Memory Technologies, Inc., Hefei, Anhui 230601 (CN)
(72) Inventor: TIAN, Kai, Hefei, Anhui 230601 (CN); WANG, Yuxia, Hefei, Anhui 230601 (CN)
(74) Representative: V.O.
(86) International application number: PCT/CN2021/105250
(87) International publication number: WO 2022/088749

(56) References cited:
- CN-A- 1 542 861
- CN-A- 104 270 122
- CN-A- 104 716 929
- US-A1- 2017 117 887
- US-A1- 2019 215 146
- US-B1- 9 030 244
- US-B1- 10 249 354

## Description

### CROSS-REFERENCE TO RELATED APPLICATION

The application claims priority to Chinese Patent Application No. 202011173755.3, filed to the China National Intellectual Property Administration on October 28, 2020 and entitled "Calibration Circuit, Memory and Calibration Method".

### TECHNICAL FIELD

The embodiments of the disclosure relate, but are not limited, to a calibration circuit, a memory and a calibration method.

### BACKGROUND

A semiconductor memory is used in many electronic systems, so as to store retrievable data. As the demand for a faster electronic system, greater data capacity and less power consumption is growing, in order to meet changing needs, the semiconductor memory may need to be faster, store more data and use less power.

Usually, the semiconductor memory is controlled by providing commands, memory addresses and clocks to a memory, and furthermore, various commands, memory addresses and clocks may be provided by a memory controller. These three types of signals may control the memory to perform various storage operations, such as a read operation for reading data from the memory, and a write operation for storing data in the memory. Based on a known sequence related to a "related command" received by the memory, data is transferred between the memory and the memory controller. Specifically, a system clock configured to time the commands and the addresses may be provided to the memory, furthermore, a data clock may also be provided to the memory, and the data clock is used as a time sequence of reading data and a time sequence of writing data. Moreover, the memory may also provide a clock to the controller, as a time sequence for transmitting data to the controller. An external clock provided to the memory is configured to generate an internal clock, and the internal clock controls time sequences of various internal circuits during a memory operation of the memory. The time sequences of the internal circuits during operation of the memory are critical, furthermore, deviation of the internal clock may cause wrong operation. Deviation of the clock may include duty cycle distortion, that is, the duty cycle of a clock signal deviates from a preset duty cycle.

Therefore, the memory is required to have a Duty Cycle Adjust (DCA) function and a Duty Cycle Monitor (DCM) function, that is, the memory may include a DCA circuit and a DCM circuit. The DCA circuit may be configured to adjust the duty cycle of the internal clock generated by the external clock, and the DCM circuit may be configured to monitor whether the duty cycle of the clock deviates from the preset duty cycle or not.

Patent Application Publication US 2017/0117887 A1 discloses a duty cycle corrector (DCC). The DCC includes a duty corrector circuit configured to adjust a duty of an input signal to output a duty-adjusted signal; a duty detector circuit configured to generate a correction code associated with the adjustment of the duty, based on a charge pump operation and a counting operation; and a timing controller configured to generate a first control signal associated with the charge pump operation and a second control signal associated with the counting operation in synchronization with a first clock.

US Patent US 9,030,244 B1 discloses an integrated circuit. The integrated circuit includes a duty cycle detection circuit, a comparator circuit, and a tuning circuit. The duty cycle detection circuit receives a clock signal, such as a system clock signal, and detects the level of duty cycle distortion in the clock signal. The comparator circuit then generates an output based on the level of duty cycle distortion that is detected in the clock signal. The tuning circuit may accordingly adjust the clock signal based on the output generated by the comparator circuit to produce an adjusted clock output signal. As an example, the clock output signal produced by the tuning circuit after the adjustment may have a 50% (or significantly close to 50%) duty cycle.

### SUMMARY

The invention is defined as set forth in the independent claims 1 and 8. Embodiments of the invention are defined in the dependent claims.

The embodiments of the disclosure further provide a memory, which can include the abovementioned calibration circuit.

### BRIEF DESCRIPTION OF THE DRAWINGS

The one or more embodiments are exemplified by the pictures in the corresponding drawings, and the exemplary descriptions do not constitute a limitation to the embodiments. Elements in the drawings having the same reference numerals are denoted by like elements, and unless otherwise stated, the figures in the drawings do not constitute a proportional limitation.
FIG. 1 is a functional block diagram of a calibration circuit according to an embodiment of the disclosure.
FIG. 2 is a schematic structural diagram of a calibration circuit according to an embodiment of the disclosure.
FIG. 3 is a schematic flowchart of a calibration method according to another embodiment of the disclosure.

### DETAILED DESCRIPTION

It can be seen from BACKGROUND that, the working frequency of a memory is faster and faster at present, the demand for the duty cycle of an input signal is more and more strict, and it is very important to calibrate and monitor the duty cycle of the input signal by using a DCA function and a DCM function meeting requirements. Moreover, a differential input circuit that is configured to receive an external clock signal to generate an internal clock signal is in the memory, and the inherent circuit characteristics of the differential input circuit can cause the duty cycle deviation of the internal clock signal. If the influence of the differential input circuit on the duty cycle deviation is not detected and calibrated in time, the reading and writing performance of the memory will be affected.

In order to solve the above problems, the embodiments of the disclosure provide a calibration circuit, after a first oscillation signal and a second oscillation signal with duty cycles in a first preset range pass through the differential input circuit, a first internal signal and a second internal signal are output, and the first internal signal and the second internal signal can be used as actual input signals when the memory is tested. As a comparison unit detects the duty cycle of the first internal signal and the duty cycle of the second internal signal, and a logical unit controls the differential input circuit based on a detection result, the duty cycle of the first internal signal and the duty cycle of the second internal signal can be ensured to be steady and stabilized in a second preset range, and testing is executed by using the first internal signal and the second internal signal, such that the accuracy of a test result can be improved. Moreover, the calibration circuit also has a DCM function and a DCM function, and can calibrate the working state of the differential input circuit, such that the influence of the differential input circuit on duty cycle deviation is reduced, even avoided, and the reading and writing performance of the memory with the calibration circuit are improved.

In order to make the purposes, technical solutions and advantages of the embodiments of the disclosure clearer, the various embodiments of the disclosure are described in detail in combination with the drawings below. However, it can be understood by those of ordinary skill in the art that: in order to enable a reader to understand the disclosure better, many technical details are provided in the various embodiments of the disclosure. But, even if these technical details and a variety of change and modifications based on the various embodiments below do not exist, the technical solutions required to be protected by the disclosure may also be realized.

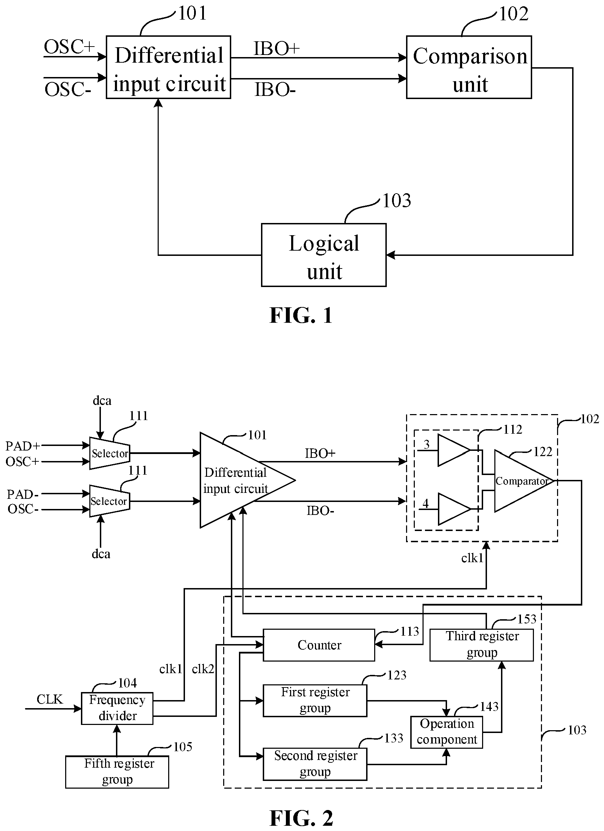

FIG. 1 is a functional block diagram of a calibration circuit according to an embodiment of the disclosure. FIG. 2 is a schematic structural diagram of a calibration circuit according to an embodiment of the disclosure.

Referring to FIG. 1 and FIG. 2, in the embodiment, the calibration circuit can include: a differential input circuit 101, configured to receive a first oscillation signal OSC+ and a second oscillation signal OSC-, the first oscillation signal OSC+ and the second oscillation signal OSC- having the same frequency and opposite phases, the duty cycle of the first oscillation signal OSC+ and the duty cycle of the second oscillation signal OSC- being in a first preset range, and the differential input circuit 101 configured to output a first internal signal IBO+ and a second internal signal IBO-; a comparison unit 102, connected to an output end of the differential input circuit 101, and configured to compare the duty cycle of the first internal signal IBO+ and/or the duty cycle of the second internal signal IBO-; and a logical unit 103, connected to the comparison unit 102 and the differential input circuit 101, configured to control the differential input circuit 101 according to an output result of the comparison unit 102, such that the duty cycle of the first internal signal IBO+ and/or the duty cycle of the second internal signal IBO- reaches a second preset range.

The calibration circuit can be built in the memory, can not only receive an external clock signal to generate an internal clock signal, but also receive the first oscillation signal and the second oscillation signal for testing to generate the first internal signal and the second internal signal, in addition, the duty cycle of the first internal signal and the duty cycle of the second internal signal can be stabilized in the second preset range, such that the accuracy of a test result of a test memory is improved. Moreover, the calibration circuit can also realize the DCA function and the DCM function of the memory, as well as the calibration function on the differential input circuit, and the duty cycle deviation problem of the differential input circuit on the clock signal is avoided.

The calibration circuit provided by the embodiment will be described in detail in combination with the drawings.

The first oscillation signal OSC+ and the second oscillation signal OSC- are differential clock signals, furthermore, the duty cycle of the first oscillation signal OSC+ and the duty cycle of the second oscillation signal OSC- are in the first preset range, that is, the first oscillation signal OSC+ and the second oscillation signal OSC- are highquality signals. In an example, the first preset range can be 48% - 52%.

Moreover, in the embodiment, the first oscillation signal OSC+ and the second oscillation signal OSC- can have high-frequency characteristics, that is, the frequency of the first oscillation signal OSC+ and the frequency of the second oscillation signal OSC- are equivalent to the frequency of the clock signal required for the memory to read and write, and the equivalence here can be either the same frequency or the frequency difference is within a test allowable range. For example, the frequency of the first oscillation signal OSC+ and the frequency of the second oscillation signal OSC- can reach 3.2 GHz or 4.8 GHz, even 6.4 GHz.

In addition, the first oscillation signal OSC+ and the second oscillation signal OSC- can be provided by an oscillation circuit built in the memory.

In the embodiment, the differential input circuit 101 can include an input buffer, configured to receive the differential first oscillation signal OSC+ and second oscillation signal OSC-, and output the differential first internal signal IBO+ and second internal signal IBO-.

Moreover, in the embodiment, the differential input circuit 101 can also be configured to receive a first external signal PAD+ and a second external signal PAD-, furthermore, the first external signal and the second external signal have the same frequency and opposite phases, that is, the first external signal PAD+ and the second external signal PAD- are also differential signals. Correspondingly, the calibration circuit can also include a selector 111,. The first oscillation signal OSC+, the second oscillation signal OSC-, the first external signal PAD+ and the second external signal PAD- are connected to the differential input circuit 101 through the selector 111. By taking the first oscillation signal OSC+ and the second oscillation signal OSC- as a first differential pair signal and taking the first external signal PAD+ and the second external signal PAD- as a second differential pair signal, the selector 111 is configured to select one of the first differential pair signal and the second differential pair signal to input into the differential input circuit 101.

As the differential input circuit 101 has inherent circuit characteristics, even if the duty cycle of the first oscillation signal OSC+ and the duty cycle of the second oscillation signal OSC- meet requirements, the duty cycle of the first internal signal IBO+ and the duty cycle of the second internal signal IBO- obtained after being output through the differential input circuit 101 may deviate. Therefore, the comparison unit 102 is adopted to detect the duty cycle of the first internal signal IBO+ and the duty cycle of the second internal signal IBO-.

Because the first internal signal IBO+ and the second internal signal IBO- are differential signals, the sum of the duty cycle of the first internal signal IBO+ and the duty cycle of the second internal signal IBO- is 100%, and the comparison unit 102 is configured to detect the duty cycles of the differential first internal signal IBO+ and second internal signal IBO-. Specifically, the operation that the comparison unit 102 compares the duty cycle of the first internal signal IBO+ and/or the duty cycle of the second internal signal IBO- can include at least one of the following three conditions.

The comparison unit 102 compares the duty cycle of the first internal signal IBO+. Specifically, the comparison unit 102 compares whether the duty cycle of the first internal signal IBO+ reaches the second preset range or not, and the second preset range can be the same as the first preset range, for example, the second preset range can be 48% - 52%. If the comparison unit 102 compares that the duty cycle of the first internal signal IBO+ is in the second preset range, it shows that the duty cycle of the second internal signal IBO- is also in the second preset range. If the comparison unit 102 compares that the duty cycle of the first internal signal IBO+ is not in the second preset range, it shows that the duty cycle of the second internal signal IBO- is also not in the second preset range.

The comparison unit 102 compares the duty cycle of the second internal signal IBO-. Specifically, the comparison unit 102 compares whether the duty cycle of the second internal signal IBO- reaches the second preset range or not, and the second preset range can be 48% - 52%. If the comparison unit 102 compares that the duty cycle of the second internal signal IBO- is in the second preset range, it shows that the duty cycle of the first internal signal IBO+ is also in the second preset range. If the comparison unit 102 compares that the duty cycle of the second internal signal IBO- is not in the second preset range, it shows that the duty cycle of the first internal signal IBO+ is also not in the second preset range.

The comparison unit 102 compares the duty cycle of the first internal signal IBO+ and the duty cycle of the second internal signal IBO-. Specifically, the comparison unit 102 compares whether a difference value between the duty cycle of the first internal signal IBO+ and the duty cycle of the second internal signal IBO- is in a preset difference value range or not, and the preset difference value range can be -4% - 4%. If the comparison unit 102 compares that the difference value is in the preset difference value range, it shows that the duty cycle of the first internal signal IBO+ and the duty cycle of the second internal signal IBO- are in the second preset range, otherwise, the duty cycle of the first internal signal IBO+ and the duty cycle of the second internal signal IBO- do not reach the second preset range.

It should be noted that, both the numerical ranges of the abovementioned second preset range and preset difference value range are exemplary descriptions. The embodiments do not limit the second preset range and the preset difference value range, and the second preset range and the preset difference value range can be reasonably set according to actual performance requirements of the memory.

In the embodiment, the comparison unit 102 can include: an integral unit 112 with a first input end 3 and a second input end 4, the first input end 3 receiving one of the first internal signal IBO+ or the second internal signal IBO-, and the second input end 4 receiving the other of the first internal signal IBO+ or the second internal signal IBO-; and a comparator 122, connected to an output end of the integral unit 112.

Specifically, the integral unit 112 can include two integral circuits, furthermore, the first input end 3 is used as an input end of one integral circuit, and the second input end 4 is used as an input end of the other integral circuit. The comparator 122 is configured to compare outputs of the two integral circuits and output high level or low level.

More specifically, the comparison unit 102 performs integral operation on the input first internal signal IBO+ and the second internal signal IBO- through the two integral circuits, furthermore, the result of the integral operation is input into the comparator 122, and the comparator 122 outputs a comparison result.

Taking the first internal signal IBO+ as a positive end (duty+) and the second internal signal IBO- as a negative end (duty-) as an example, in one example, if the output of the comparator 122 is at a high level, it shows that the duty cycle of the first internal signal IBO+ is greater than the duty cycle of the second internal signal IBO-; and if the output of the comparator 122 is at a low level, it shows that the duty cycle of the first internal signal IBO+ is less than the duty cycle of the second internal signal IBO-.

It should be noted that, the abovementioned corresponding relationship among the output results of the comparison unit 102, the duty cycle of the first internal signal IBO+ and the duty cycle of the second internal signal IBO- is merely exemplary; the embodiments do not limit the corresponding relationship among the high level, the low level, the duty cycle of the first internal signal IBO+ and the duty cycle of the second internal signal IBO-, as long as the corresponding relationship that different output results correspond to different duty cycles of the first internal signal IBO+ and different duty cycles of the second internal signal IBO- is guaranteed.

As shown in FIG. 2, the output result of the comparison unit 102 can be sampled and output through a sampling clock clk1. In the embodiment, the comparison unit 102 is driven by a sampling clock clk1, and the frequency of the sampling clock clk1 is lower than the frequency of the first internal signal IBO+ and/or the frequency of the second internal signal IBO-. The faster the frequency of the sampling clock clk1 is, the greater the sampling error is. The slower the frequency of the sampling clock clk1 is, the smaller the sampling error is, but the longer the test time is. Therefore, the optimal frequency of the sampling clock clk1 can be comprehensively selected according to the sampling error and the test time.

In the embodiment, a clock generation circuit can also include a frequency divider 104, configured to receive an external clock signal CLK, and generate the sampling clock clk1. The external clock signal CLK can be provided by a test machine or a memory.

Moreover, it can be seen from the foregoing analysis that, if the frequency of the sampling clock clk1 is adjustable, different frequencies of the sampling clock clk1 can be selected according to actual conditions, therefore, in the embodiment, the clock generation circuit can also include a fifth register group 105, connected with the frequency divider 104, and adapted to configure the frequency of the sampling clock. The fifth register group 105 can be a mode register.

As inherent characteristics of the comparison unit 102 can cause input deviation, in order to eliminate the error of the test result caused by the input deviation of the comparison unit 102, in the embodiment, the comparison unit 102 can also be configured to be that the first input end 3 and the second input end 4 are interchangeable. Specifically, the comparison unit 102 is configured below.

The first input end 3 of the integral unit 112 is configured to receive the first internal signal IBO+ when a flipping identification signal is at a low level, and is configured to receive the second internal signal IBO- when the flipping identification signal is at a high level. The second input end 4 of the integral unit 112 is configured to receive the second internal signal IBO- when the flipping identification signal is at a low level, and is configured to receive the first internal signal IBO+ when the flipping identification signal is at a high level. Herein, the mode register is in the memory, the flipping identification signal can be provided by the mode register, for example, in LPDDR4 or LPDDR5 or LPDDR6, the flipping identification signal can be defined as DCM MR OP[1], if the DCM MR OP[1] is 0, it shows that the flipping identification signal is at a low level, and if the DCM MR OP[1] is 1, it shows that the flipping identification signal is at a high level.

The logical unit 103 controls the differential input circuit 101 based on a detection result of the comparison unit 102, and adjusts circuit characteristics of the differential input circuit 101, such that the duty cycle of the first internal signal IBO+ and the duty cycle of the second internal signal IBO- output by the adjusted differential input circuit 101 reach the second preset range.

Specifically, the logical unit 103 can include: a counter 113, configured to adjust the duty cycle of the first internal signal IBO+ and/or the second internal signal IBO-; a first register group 123, configured to store the first value of the counter 113 according to the output of the comparator 122 when the flipping identification signal is at a low level; and a second register group 133, configured to store the second value of the counter 113 according to the output of the comparator 122 when the flipping identification signal is at a high level.

Specifically, the counter 113 has the functions of adjusting the circuit characteristics of the differential input circuit 101 and changing the duty cycle of the first internal signal IBO+ and the duty cycle of the second internal signal IBO-, and the duty cycle of the first internal signal IBO+ and the duty cycle of the second internal signal IBO- change monotonically, for example, the duty cycle changes from minimum to maximum or from maximum to minimum in one counting cycle. In one counting cycle, the output result of the comparator 122 will have only one inversion point, the value of the counter 113 corresponding to the inversion point is the setting where the duty cycle of the first internal signal IBO+ and the duty cycle of the second internal signal IBO- output by the differential input circuit 101 are the closest to the second preset range, and the value used as the value of the counter 113 is stored in the first register group 123 or the second register group 133.

More specifically, when the flipping identification signal is at a low level, the first value of the counter 113 is stored according to output of the comparator 122, and the first value is stored in the first register group 123. When the flipping identification signal is at a high level, the second value of the counter 113 is stored according to output of the comparator 122, and the second value is stored in the second register group 133. In order to conveniently understand this, the working principle of the logical unit 103 will be described in detail below.

When the flipping identification signal is at a low level, the first input end 3 of the integral unit 112 is configured to receive the first internal signal IBO+, and the second input end 4 is configured to receive the second internal signal IBO-; the counter 113 starts counting, for example, the counter 113 counts from 0 to 31 in one counting cycle, and meanwhile, the duty cycle of the first internal signal IBO+ and the duty cycle of the second internal signal IBO- output by the differential input circuit 101 also change from minimum to maximum (such as from 40% to 60%) or from maximum to minimum. Therefore, in one counting cycle (such as from 0 to 31), the comparator 122 will have only one inversion point, the value of the counter 113 corresponding to the inversion point is the first value, the first value is the setting where the duty cycle of the first internal signal IBO+ output by the differential input circuit 101 is the closest to the second preset range, for example, the first value can be that the duty cycle is the closest to 50%, and the first value is stored in the first register group 123.

When the flipping identification signal is at a high level, the first input end 3 of the integral unit 112 is configured to receive the second internal signal IBO-, the second input end 4 is configured to receive the first internal signal IBO+, that is, input ends of the comparison unit 102 are interchangeable, the counter 113 enters a new counting cycle, for example, the counter 113 counts from 0 to 31, and similarly, the second value of the counter 113 corresponding to the output inversion point of the comparator 122 is stored in the second register group 133.

It should be noted that, the abovementioned counting cycle from 0 to 31 is merely exemplary description, the counting type of the counter 113 is not limited in the embodiment, the counter 113 can be either an addition counter or a subtraction counter, which can be either a sequential increase or decrease count, or a step-by-step increase or decrease count, and monotonic change of the counter 113 in a single counting cycle is ensured.

The first input end 3 and the second input end 4 of the comparison unit 102 are interchangeable, in a manner of controlling the differential input circuit 101 through counting twice, the adverse effect caused by the input deviation of the comparison unit 102 itself can be eliminated, and the accuracy of the test result is further improved.

Moreover, the logical unit 103 can also include: an operation component 143, connected to the first register group 123 and the second register group 133, and configured to perform addition, subtraction, multiplication and division on output of the first register group 123 and the second register group 133; and a third register group 153, connected to the operation component 143, and configured to store an output result of the operation component 143.

Specifically, the output of the first register group 123 refers to the first value stored in the first register group 123, and the output of the second register group 133 refers to the second value stored in the second register group 133. In the embodiment, the operation component 143 adds the first value and the second value and divides them by 2 to obtain an average value, the average value is used as an output result of the operation component 143, and the average value is stored in the third register group 153. Because the average value already eliminates the input deviation of the comparison unit 102 itself, the average value is the setting where the duty cycle of the first internal signal IBO+ and the duty cycle of the second internal signal IBO- output by the differential input circuit 101 are the closest to the second preset range, for example, the duty cycle of the first internal signal IBO+ and the duty cycle of the second internal signal IBO- are the closest to 50%.

It should be understood that, the average value can be an integer rounded up by adding the first value and the second value divided by 2, or an integer rounded down by adding the first value and the second value divided by 2.

It should be noted that, in the embodiment, averaging of the first value and the second value is taken as an example, and in other embodiments, other operation modes can also be used to operate the first value and the second value.

The first register group 123, the second register group 133 and the third register group 153 can be mode registers.

In the embodiment, the comparison unit 102 is driven by a calculator clock, and the frequency of the calculator clock is lower than the frequency of the first internal signal IBO+ and/or the frequency of the second internal signal IBO-. The frequency of the calculator clock is adjustable, and the frequency of the calculator clock is reasonably selected according to the speed of adjusting the differential input circuit 101.

Moreover, the frequency of the sampling clock can be the same as the frequency of the calculator clock. The frequency divider can also be configured to receive an external clock signal, and generate the sampling clock and the calculator clock, and similarly, the fifth register group can also be adapted to configure the frequency of the calculator clock.

The value stored in the third register group 153 corresponds to the setting of the differential input circuit 101, and at this time, the duty cycle of the differential input circuit 101 is selectively switched from the counter 113 to the third register group 153, such that the differential input circuit fixedly outputs the first internal signal IBO+ and the second internal signal IBO- at an optimal duty cycle. It should be understood that, during a period that the differential input circuit 101 fixedly outputs the first internal signal IBO+ and the second internal signal IBO- at the optimal duty cycle, the comparison unit 102 can continuously compare the duty cycle of the first internal signal IBO+ and/or the duty cycle of the second internal signal IBO-. When the duty cycle of the first internal signal IBO+ and the duty cycle of the second internal signal IBO- depart from the preset range, the problem can be detected in time.

Moreover, in the embodiment, a control end of the selector 111 is configured to receive a calibration enable signal dca, when the calibration enable signal dca is at a low level, the first external signal PAD+ and the second external signal PAD- are input into the differential input circuit 101, while when the calibration enable signal dca is at a high level, the first oscillation signal OSC+ and the second oscillation signal OSC- are input into the differential input circuit 101.

When the calibration enable signal dca is at a high level, the calibration circuit enters a duty cycle calibration state, the first oscillation signal OSC+ and the second oscillation signal OSC- correspondingly having an initial duty cycle are input into the differential input circuit 101, so as to execute duty cycle calibration or duty cycle adjustment, thereby realizing the DCA function. When the calibration enable signal dca is at a low level, the calibration circuit quits the duty cycle calibration state, the first external signal PAD+ and the second external signal PAD- are input into the differential input circuit 101, so as to execute duty cycle detection or duty cycle monitoring, thereby realizing the DCM function.

According to the calibration circuit provided by the embodiment, through the differential input circuit 101, the comparison unit 102 and the logical unit 103, the stable first internal signal IBO+ and second internal signal IBO- can be generated in the memory, and the first internal signal IBO+ and the second internal signal IBO- meet the requirements of a high-frequency working signal of the memory. Therefore, the first internal signal IBO+ and the second internal signal IBO- can be used as test input signals for testing the memory, such that the memory can achieve a built-in self-testing function; There is no need to use an additional test machine to provide test input signals, and meanwhile, the problem that the test machine is difficult to provide a high-frequency test input signal is solved.

Meanwhile, the calibration circuit can also calibrate the differential input circuit 101, when the calibration circuit is used in the memory, the duty cycle deviation caused by the differential input circuit 101 itself can be reduced, such that the reading and writing operation performance of the memory is improved, for example, the noise allowance is improved, and the signal integrity is improved.

Moreover, in the embodiment, the comparison unit 102 detects output of the differential input circuit 101, furthermore, the logical unit 103 controls the differential input circuit 101 based on the output result of the comparison unit 102, such that the duty cycle of the first internal signal IBO+ and the duty cycle of the second internal signal IBO- can be stabilized in the second preset range. The adverse effect of duty cycle deviation on the test accuracy is avoided, and the test accuracy of testing the memory by utilizing the first internal signal IBO+ and the second internal signal IBO- is improved. For example, the duty cycle of the first internal signal IBO+ and the duty cycle of the second internal signal IBO- can be precisely controlled at 50%.

Meanwhile, the calibration circuit provided by the embodiment also has the DCM function and the DCA function.

Correspondingly, the embodiments of the disclosure further provide a memory, which can include the calibration circuit provided by the abovementioned embodiments. Specifically, the memory can be a Dynamic Random Access Memory (DRAM), a Static Random Access Memory (SRAM), a Magnetic Random Access Memory (MRAM), a Ferroelectric Random Access Memory (FeRAM), a Phase Change Random Access Memory (PCRAM), NAND, NOR, etc.

It can be seen from the above analysis that, high-speed first internal signals and second internal signals for testing can be generated in the memory, furthermore, the duty cycles of the first internal signals and second internal signals can be maintained in the second preset range, such that there is no need to use an additional test machine to provide test signals, and thus, the test accuracy of testing the memory is easily improved.

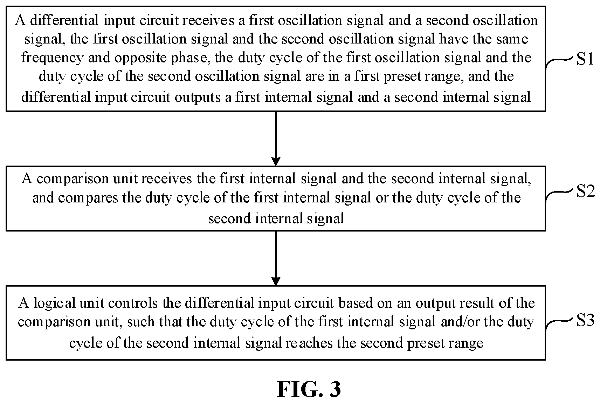

Correspondingly, the embodiments of the disclosure further provide a calibration method. FIG. 3 is a schematic flowchart of a calibration method according to an embodiment of the disclosure. The calibration method in the embodiment of the disclosure will be described in detail in combination with the drawings. It should be noted that, the calibration method can be executed by utilizing the calibration circuit provided by the abovementioned embodiments.

Referring to FIG. 2 and FIG. 3, in the embodiment, the calibration method can include the following steps.

At S1, a differential input circuit receives a first oscillation signal OSC+ and a second oscillation signal OSC-, the first oscillation signal OSC+ and the second oscillation signal OSC- have the same frequency and opposite phases, the duty cycle of the first oscillation signal OSC+ and the duty cycle of the second oscillation signal OSC- are in a first preset range, and the differential input circuit outputs a first internal signal IBO+ and a second internal signal IBO-.

Specifically, the first oscillation signal OSC+ and the second oscillation signal OSC- are signals with a steady duty cycle, and for example, both the duty cycle of the first oscillation signal OSC+ and the duty cycle of the second oscillation signal OSC- are 50%.

At S2, a comparison unit receives the first internal signal IBO+ and the second internal signal IBO-, and compares the duty cycle of the first internal signal IBO+ or the duty cycle of the second internal signal IBO-.

The duty cycle of the first internal signal IBO+ and the duty cycle of the second internal signal IBO- output by the differential input circuit can be deviated, for example, the duty cycle of the first internal signal IBO+ becomes 40%, and the duty cycle of the second internal signal IBO- becomes 60%.

Specifically, when the flipping identification signal is at a low level, the comparison unit compares the duty cycle of the first internal signal IBO+, and when the flipping identification signal is at a high level, the comparison unit compares the duty cycle of the second internal signal IBO-.

The comparison unit can include: an integral unit with a first input end and a second input end, the first input end receiving one of the first internal signal IBO+ or the second internal signal IBO-, and the second input end receiving the other of the second internal signal IBO- or the first internal signal IBO+; and a comparator, connected to an output end of the integral unit.

When the flipping identification signal is at a low level, the first input end receives the first internal signal IBO+ and the second input end receives the second internal signal IBO-, and the comparator compares the duty cycle of the first internal signal IBO+ and has a corresponding output. The comparator compares the duty cycle of the first internal signal IBO+ with: the duty cycle of the second internal signal IBO-, or the preset duty cycle.

When the flipping identification signal is at a high level, the first input end receives the second internal signal IBO- and the second input end receives the first internal signal IBO+, and the comparator compares the duty cycle of the second internal signal IBO- and has a corresponding output. The comparator compares the duty cycle of the second internal signal IBO- with: the duty cycle of the first internal signal IBO+, or the preset duty cycle.

An output result of the comparison unit represents a difference value between the duty cycle of the first internal signal IBO+ and the duty cycle of the second internal signal IBO-. For example, if an output result of the comparison unit is at a high level, it shows that the duty cycle of the first internal signal IBO+ is greater than the duty cycle of the second internal signal IBO-; and if an output result of the comparison unit is at a low level, it shows that the duty cycle of the first internal signal IBO+ is less than the duty cycle of the second internal signal IBO-.

At S3, a logical unit controls the differential input circuit based on an output result of the comparison unit, such that the duty cycle of the first internal signal IBO+ and/or the duty cycle of the second internal signal IBO- reach the second preset range.

Specifically, the logical unit can include a counter, a first register group and a second register group. The differential input circuit is controlled through the counter, such that the duty cycle of the first internal signal IBO+ and the duty cycle of the second internal signal IBO- are adjusted.

When the flipping identification signal is at a low level, the counter counts from U to V, when the value of the counter is U, the duty cycle of the corresponding first internal signal IBO+ is X%, when the value of the counter is V, the duty cycle of the corresponding first internal signal IBO+ is Y%, and when the output result of the comparison unit is changed from the low level to the high level, the value of the counter corresponding to the counter at this time is stored in the first register group. For example, U can be 0, V can be 7, X can be 40, and Y can be 60%.

When the flipping identification signal is at a high level, the counter counts from U to V, when the value of the counter is U, the duty cycle of the corresponding second internal signal IBO- is Y%, when the value of the counter is V, the duty cycle of the corresponding second internal signal IBO- is X%, when the output result of the comparison unit is changed from the high level to the low level, the value of the counter corresponding to the counter at this time is stored in the second register group. For example, U can be 0, V can be 7, X can be 40, and Y can be 60%.

Specifically, for example, when the flipping identification signal is at a low level, the first input end receives the first internal signal IBO+ and the second input end receives the second internal signal IBO-, and the counter counts from 0 to 7 in one counting cycle. When the output result of the comparison unit is at a low level, it shows that the duty cycle of the first internal signal IBO+ is less than the duty cycle of the second internal signal IBO-; and when the output result of the comparison unit is at a high level, it shows that the duty cycle of the first internal signal IBO+ is greater than the duty cycle of the second internal signal IBO-. Therefore, the output result of the comparison unit jumps from the low level to the high level, corresponding to an inversion point, for example, the value of the counter at this time is 3, and the counter value 3 of the counter corresponding to the inversion point used as the first value is stored in the first register group.

For example, when the flipping identification signal is at a high level, the first input end receives the second internal signal IBO- and the second input end receives the first internal signal IBO+, and the counter counts from 0 to 7 in one counting cycle. When the output result of the comparison unit is at a high level, it shows that the duty cycle of the first internal signal IBO+ is less than the duty cycle of the second internal signal IBO-; and when the output result of the comparison unit is at a low level, it shows that the duty cycle of the first internal signal IBO+ is greater than the duty cycle of the second internal signal IBO-. Therefore, the output result of the comparison unit jumps from the high level to the low level, corresponding to an inversion point, for example, the value of the counter at this time is 4, and the counter value 4 of the counter corresponding to the inversion point used as the second value is stored in the second register group.

It should be noted that, when the flipping identification signal is at a low level, the counter counts from 0 to 7, the duty cycle of the first internal signal IBO+ changes monotonically, for example, the duty cycle of the first internal signal IBO+ can be in preset step-by-step increasing, and if the counter value of the counter increases by 1, the duty cycle of the first internal signal IBO+ increases by ((60 - 40) / 8)%. It should be noted that, when the flipping identification signal is at a high level and the counter counts from 0 to 7, the duty cycle of the second internal signal IBO- changes monotonically. For example, the duty cycle of the first internal signal IBO+ can present a preset stepwise increase, and if the counter value of the counter increases by 1, the duty cycle of the first internal signal IBO+ increases by ((60 - 40) / 8)%.

The logical unit can also include an operation component and a third register group, the operation component performs addition, subtraction, multiplication and division on output of the first register group and the second register group, and stores the obtained numerical value H in the third register group, herein, H is a positive integer, and H is greater than or equal to U and less than or equal to V

In the embodiments, the numerical value H is the sum of the first value and the second value divided by 2, that is, the numerical value H is the average of the first value and the second value, the numerical value H is the setting corresponding to the first internal signal IBO+ and the second internal signal IBO- reaching the second preset range, for example, H is equal to (3 + 4) / 2, that is, H is equal to 3.5, and H can also be rounded up to 3 or down to 4. That is, the duty cycle of the second internal signal IBO+ corresponding to the numerical value H is in the second preset range, and the second preset range can be 48% - 52%, such as 50%.

After the numerical value H is obtained, the differential input circuit is no longer controlled by the counter, but the numerical value H is used as the setting of the differential input circuit, such that the differential input circuit outputs the first internal signal IBO+ with a preset duty cycle, and the corresponding second internal signal IBO- is also a signal whose duty cycle meets the requirements.

The solution of the calibration method provided in the embodiment can generate the first internal signal IBO+ and the second internal signal IBO- with high speed and high quality, the first internal signal IBO+ and the second internal signal IBO- are clock signals with stable duty cycles, and the first internal signal IBO+ and the second internal signal IBO- can be used as clock signals required for reading and writing operations of the memory. Moreover, the calibration method can also calibrate the differential input circuit, timely detect the influence of the differential input circuit on the duty cycle, and ensure that the duty cycle of the first internal signal IBO+ and the duty cycle of the second internal signal IBO- output through the differential input circuit reach the second preset range. For example, referring to FIG. 2 and FIG. 3, through the calibration method provided by the embodiment, the duty cycle of the first internal signal IBO+ is adjusted from 40% to 50%, and the duty cycle of the second internal signal IBO- is adjusted from 60% to 50%. Therefore, the deviation on the clock duty cycle caused by the differential input circuit 101 is eliminated.

### INDUSTRIAL APPLICABILITY

The calibration circuit provided by the embodiment of the disclosure can not only generate a differential internal signal based on the first oscillation signal and the second oscillation signal, but also has the DCM function and the DCA function to ensure that the duty cycle of the first internal signal and the duty cycle of the second internal signal generated by the calibration circuit are stable in the second preset range; correspondingly, when the first internal signal and the second internal signal are used to test the memory, it is conducive to avoid the problem of test deviation caused by the duty cycle deviation of the input signal, improve the test accuracy of the memory, and enable the memory to realize the DCM function and the DCA function.

## Claims

1. A calibration circuit, comprising:
a differential input circuit (101), configured to receive a first oscillation signal and a second oscillation signal, the first oscillation signal and the second oscillation signal having a same frequency and opposite phases, a duty cycle of the first oscillation signal and a duty cycle of the second oscillation signal being in a first preset range, and the differential input circuit (101) configured to output a first internal signal and a second internal signal;
a comparison unit (102), connected to an output end of the differential input circuit (101), and configured to compare the duty cycle of the first internal signal and/or the duty cycle of the second internal signal; and
a logical unit (103), connected to the comparison unit (102) and the differential input circuit (101), and configured to control the differential input circuit (101) according to an output result of the comparison unit (102), such that the duty cycle of the first internal signal and/or the duty cycle of the second internal signal reaches a second preset range,
wherein the comparison unit (102) comprises:
an integral unit (112) with a first input end and a second input end, the first input end configured to receive one of the first internal signal or the second internal signal, and the second input end configured to receive another of the second internal signal or the first internal signal; and
a comparator, connected to an output end of the integral unit (112),
wherein the first input end of the integral unit (112) is configured to receive the first internal signal when a flipping identification signal is at a low level, and receive the second internal signal when the flipping identification signal is at a high level; and
the second input end of the integral unit (112) is configured to receive the second internal signal when the flipping identification signal is at a low level, and receive the first internal signal when the flipping identification signal is at a high level,
wherein the logical unit (103) comprises:
a counter (113), configured to adjust the duty cycle of the first internal signal and/or the duty cycle of the second internal signal;
a first register group (123), configured to store a first value of the counter (113) according to output of the comparator when the flipping identification signal is at a low level, wherein the first value corresponds to an inversion point where the output of the comparator jumps from a low level to a high level; and
a second register group (133), configured to store a second value of the counter (113) according to output of the comparator when the flipping identification signal is at a high level, wherein the second value corresponds to an inversion point where the output of the comparator jumps from the high level to the low level,
wherein the logical unit (103) further comprises:
an operation component (143), connected to the first register group (123) and the second register group (133), and configured to perform addition, subtraction, multiplication and division on output of the first register group (123) and the second register group (133); and
a third register group (153), connected to the operation component (143), and configured to store an output result of the operation component (143),
wherein the duty cycle of the first internal signal corresponding to the output result is in the second preset range.

2. The calibration circuit of claim 1, wherein the comparison unit (102) is driven by a sampling clock, and a frequency of the sampling clock is lower than a frequency of the first internal signal and/or a frequency of the second internal signal.

3. The calibration circuit of claim 2, wherein the counter (113) is driven by a calculator clock, and a frequency of the calculator clock is lower than the frequency of the first internal signal and/or the frequency of the second internal signal, wherein the frequency of the sampling clock is same as the frequency of the calculator clock.

4. The calibration circuit of claim 3, further comprising:
a frequency divider (104), configured to receive an external clock signal, and generate the sampling clock and the calculator clock; and
a fourth register group (105), connected with the frequency divider (104), and adapted to configure the frequency of the sampling clock and the frequency of the calculator clock.

5. The calibration circuit of claim 1, wherein the differential input circuit (101) is further configured to receive a first external signal and a second external signal, and the first external signal and the second external signal have a same frequency and opposite phases,
wherein the calibration circuit further comprises:a selector (111), wherein the first oscillation signal, the second oscillation signal, the first external signal and the second external signal are connected to the differential input circuit (101) through the selector (111), and by taking the first oscillation signal and the second oscillation signal as a first differential pair signal and taking the first external signal and the second external signal as a second differential pair signal, the selector (111) is configured to select one of the first differential pair signal and the second differential pair signal to input into the differential input circuit (101).

6. The calibration circuit of claim 5, wherein a control end of the selector (111) is configured to receive a calibration enable signal, when the calibration enable signal is at a low level, the first external signal and the second external signal are input into the differential input circuit (101), and when the calibration enable signal is at a high level, the first oscillation signal and the second oscillation signal are input into the differential input circuit (101).

7. A memory, comprising:
the calibration circuit of any one of claims 1-6.

8. A calibration method, comprising:
receiving, with a differential input circuit, a first oscillation signal and a second oscillation signal, the first oscillation signal and the second oscillation signal having the same frequency and opposite phases, the duty cycle of the first oscillation signal and the duty cycle of the second oscillation signal being in a first preset range, and the differential input circuit outputting a first internal signal and a second internal signal (S 1);
receiving, with a comparison unit, the first internal signal and the second internal signal, and comparing the duty cycle of the first internal signal or the duty cycle of the second internal signal (S2); and
controlling, with a logical unit, the differential input circuit according to an output result of the comparison unit, such that the duty cycle of the first internal signal and/or the duty cycle of the second internal signal reaches a second preset range (S3),
**characterized in that**,
the receiving, with the comparison unit, the first internal signal and the second internal signal comprises:
when a flipping identification signal is at a low level, the comparison unit comparing the duty cycle of the first internal signal; and
when the flipping identification signal is at a high level, the comparison unit comparing the duty cycle of the second internal signal,
wherein, the controlling, with the logical unit, the differential input circuit according to the output result of the comparison unit comprises:
the logical unit comprising a counter, a first register group and a second register group;
when the flipping identification signal is at a low level, the counter counting from U to V, when the value of the counter is U, the duty cycle corresponding to the first internal signal being X%, when the value of the counter is V, the duty cycle corresponding to the first internal signal being Y%, and when the output result of the comparison unit is changed from the low level to the high level, the counter value corresponding to the counter at this time being stored in the first register group;
when the flipping identification signal is at a high level, the counter counting from U to V, when the value of the counter is U, the duty cycle corresponding to the second internal signal being Y%, when the value of the counter is V, the duty cycle corresponding to the second internal signal being X%, when the output result of the comparison unit is changed from the high level to the low level, the counter value corresponding to the counter at this time being stored in the second register group;
wherein both the U and V are integers, the U is less than V, both the X and Y are positive integers, the X is less than 50, and the Y is greater than 50,
wherein the controlling, with the logical unit, the differential input circuit according to the output result of the comparison unit further comprises:
the logical unit further comprising an operation component and a third register group;
the operation component performing addition, subtraction, multiplication and division on output of the first register group and the second register group, and storing the obtained numerical value H in the third register group;
wherein the H is an integer, and the H is greater than or equal to the U and less than or equal to the V, and
the duty cycle of the first internal signal corresponding to the H is in the second preset range.

## Patentansprüche

1. Kalibrierungsschaltung, umfassend:
eine Differenzeingangsschaltung (101), die so konfiguriert ist, dass sie ein erstes Oszillationssignal und ein zweites Oszillationssignal empfängt, wobei das erste Oszillationssignal und das zweite Oszillationssignal die gleiche Frequenz und entgegengesetzte Phasen haben, wobei ein Tastverhältnis des ersten Oszillationssignals und ein Tastverhältnis des zweiten Oszillationssignals in einem ersten voreingestellten Bereich liegen, und die Differenzeingangsschaltung (101) so konfiguriert ist, dass sie ein erstes internes Signal und ein zweites internes Signal ausgibt;
eine Vergleichseinheit (102), die mit einem Ausgabeende der Differenzeingangsschaltung (101) verbunden und so konfiguriert ist, dass sie das Tastverhältnis des ersten internen Signals und/oder das Tastverhältnis des zweiten internen Signals vergleicht; und
eine logische Einheit (103), die mit der Vergleichseinheit (102) und der Differenzeingangsschaltung (101) verbunden und derart konfiguriert ist, dass sie die Differenzeingangsschaltung (101) entsprechend einem Ausgabeergebnis der Vergleichseinheit (102) so steuert, dass das Tastverhältnis des ersten internen Signals und/oder das Tastverhältnis des zweiten internen Signals einen zweiten voreingestellten Bereich erreicht,
wobei die Vergleichseinheit (102) umfasst:
eine integrierte Einheit (112) mit einem ersten Eingangsende und einem zweiten Eingangsende, wobei das erste Eingangsende so konfiguriert ist, dass es entweder das erste interne Signal oder das zweite interne Signal empfängt, und das zweite Eingangsende so konfiguriert ist, dass es ein anderes des zweiten internen Signals oder des ersten internen Signals empfängt; und
einen Komparator, der mit einem Ausgabeende der integrierten Einheit (112) verbunden ist,
wobei das erste Eingangsende der integrierten Einheit (112) so konfiguriert ist, dass es das erste interne Signal empfängt, wenn ein Kippidentifikationssignal auf einem niedrigen Pegel ist, und das zweite interne Signal empfängt, wenn das Kippidentifikationssignal auf einem hohen Pegel ist; und
das zweite Eingangsende der integrierten Einheit (112) so konfiguriert ist, dass es das zweite interne Signal empfängt, wenn das Kippidentifikationssignal auf einem niedrigen Pegel ist, und das erste interne Signal empfängt, wenn das Kippidentifikationssignal auf einem hohen Pegel ist,
wobei die logische Einheit (103) umfasst:
einen Zähler (113), der zum Einstellen des Tastverhältnisses des ersten internen Signals und/oder des Tastverhältnisses des zweiten internen Signals konfiguriert ist;
eine erste Registergruppe (123), die so konfiguriert ist, dass sie einen ersten Wert des Zählers (113) entsprechend der Ausgabe des Komparators speichert, wenn das Kippidentifikationssignal auf einem niedrigen Pegel liegt, wobei der erste Wert einem Umkehrpunkt entspricht, an dem die Ausgabe des Komparators von einem niedrigen Pegel auf einen hohen Pegel springt; und
eine zweite Registergruppe (133), die so konfiguriert ist, dass sie einen zweiten Wert des Zählers (113) entsprechend der Ausgabe des Komparators speichert, wenn das Kippidentifikationssignal auf einem hohen Pegel liegt, wobei der zweite Wert einem Umkehrpunkt entspricht, an dem die Ausgabe des Komparators von dem hohen Pegel auf den niedrigen Pegel springt,
wobei die logische Einheit (103) weiterhin umfasst:
eine Operationskomponente (143), die mit der ersten Registergruppe (123) und der zweiten Registergruppe (133) verbunden und so konfiguriert ist, dass sie Addition, Subtraktion, Multiplikation und Division bei der Ausgabe der ersten Registergruppe (123) und der zweiten Registergruppe (133) durchführt; und
eine dritte Registergruppe (153), die mit der Operationskomponente (143) verbunden und so konfiguriert ist, dass sie ein Ausgabeergebnis der Operationskomponente (143) speichert,
wobei das Tastverhältnis des ersten internen Signals, das dem Ausgabeergebnis entspricht, in dem zweiten voreingestellten Bereich liegt.

2. Kalibrierungsschaltung nach Anspruch 1, wobei die Vergleichseinheit (102) von einem Abtasttakt angesteuert wird und eine Frequenz des Abtasttakts niedriger ist als eine Frequenz des ersten internen Signals und/oder eine Frequenz des zweiten internen Signals.

3. Kalibrierungsschaltung nach Anspruch 2, wobei der Zähler (113) von einem Rechnertakt angesteuert wird und eine Frequenz des Rechnertaktes niedriger ist als die Frequenz des ersten internen Signals und/oder die Frequenz des zweiten internen Signals, wobei die Frequenz des Abtasttaktes gleich der Frequenz des Rechnertaktes ist.

4. Kalibrierungsschaltung nach Anspruch 3, ferner umfassend:
einen Frequenzteiler (104), der so konfiguriert ist, dass er ein externes Taktsignal empfängt und den Abtasttakt und den Rechnertakt erzeugt; und
eine vierte Registergruppe (105), die mit dem Frequenzteiler (104) verbunden ist und geeignet ist, die Frequenz des Abtasttaktes und die Frequenz des Rechnertaktes zu konfigurieren.

5. Kalibrierungsschaltung nach Anspruch 1, wobei die Differenzeingangsschaltung (101) ferner so konfiguriert ist, dass sie ein erstes externes Signal und ein zweites externes Signal empfängt, und das erste externe Signal und das zweite externe Signal dieselbe Frequenz und entgegengesetzte Phasen haben,
wobei die Kalibrierungsschaltung weiterhin umfasst: einen Selektor (111), wobei das erste Oszillationssignal, das zweite Oszillationssignal, das erste externe Signal und das zweite externe Signal über den Selektor (111) mit der Differenzeingangsschaltung (101) verbunden sind, und indem das erste Oszillationssignal und das zweite Oszillationssignal als ein erstes Differentialpaarsignal genommen werden und das erste externe Signal und das zweite externe Signal als ein zweites Differentialpaarsignal genommen werden, der Selektor (111) so konfiguriert ist, dass er entweder das erste Differentialpaarsignal und das zweite Differentialpaarsignal zur Eingabe in die Differenzeingangsschaltung (101) auswählt.

6. Kalibrierungsschaltung nach Anspruch 5, wobei ein Steuerende des Selektors (111) so konfiguriert ist, dass es ein Kalibrierungsfreigabesignal empfängt, wenn das Kalibrierungsfreigabesignal auf einem niedrigen Pegel ist, das erste externe Signal und das zweite externe Signal in die Differenzeingangsschaltung (101) eingegeben werden, und wenn das Kalibrierungsfreigabesignal auf einem hohen Pegel ist, das erste Oszillationssignal und das zweite Oszillationssignal in die Differenzeingangsschaltung (101) eingegeben werden.

7. Speicher, umfassend:
die Kalibrierungsschaltung nach einem der Ansprüche 1 bis 6.

8. Kalibrierungsverfahren, umfassend:
Empfangen eines ersten Oszillationssignals und eines zweiten Oszillationssignals mit einer Differenzeingangsschaltung, wobei das erste Oszillationssignal und das zweite Oszillationssignal die gleiche Frequenz und entgegengesetzte Phasen haben, wobei das Tastverhältnis des ersten Oszillationssignals und das Tastverhältnis des zweiten Oszillationssignals in einem ersten voreingestellten Bereich liegen, und die Differenzeingangsschaltung ein erstes internes Signal und ein zweites internes Signal (S1) ausgibt;
Empfangen des ersten internen Signals und des zweiten internen Signals mit einer Vergleichseinheit, und Vergleichen des Tastverhältnisses des ersten internen Signals oder des Tastverhältnisses des zweiten internen Signals (S2); und
Steuern der Differenzeingangsschaltung mit einer logischen Einheit in Abhängigkeit von einem Ausgabeergebnis der Vergleichseinheit, derart dass das Tastverhältnis des ersten internen Signals und/oder das Tastverhältnis des zweiten internen Signals einen zweiten voreingestellten Bereich (S3) erreicht,
**dadurch gekennzeichnet, dass** das Empfangen des ersten internen Signals und des zweiten internen Signals mit der Vergleichseinheit umfasst:
wenn ein Kippidentifikationssignal auf einem niedrigen Pegel ist, die Vergleichseinheit das Tastverhältnis des ersten internen Signals vergleicht; und
die Vergleichseinheit das Tastverhältnis des zweiten internen Signals, wenn das Kippidentifikationssignal einen hohen Pegel hat, vergleicht,
wobei das Steuern der Differenzeingangsschaltung mit der logischen Einheit entsprechend dem Ausgabeergebnis der Vergleichseinheit umfasst:
die logische Einheit, umfassend einen Zähler, eine erste Registergruppe und eine zweite Registergruppe;
wenn das Kippidentifikationssignal auf einem niedrigen Pegel ist, der Zähler von U bis V zählt, wenn der Wert des Zählers U ist, das Tastverhältnis, das dem ersten internen Signal entspricht, X% ist, wenn der Wert des Zählers V ist, das Tastverhältnis, das dem ersten internen Signal entspricht, Y% ist, und wenn das Ausgabeergebnis der Vergleichseinheit von dem niedrigen Pegel auf den hohen Pegel geändert wird, der Zählerwert, der dem Zähler zu diesem Zeitpunkt entspricht, in der ersten Registergruppe gespeichert wird;
wenn das Kippidentifikationssignal auf einem hohen Pegel ist, der Zähler von U bis V zählt, wenn der Wert des Zählers U ist, das Tastverhältnis, das dem zweiten internen Signal entspricht, Y% ist, wenn der Wert des Zählers V ist, das Tastverhältnis, das dem zweiten internen Signal entspricht, X% ist, wenn das Ausgabeergebnis der Vergleichseinheit von dem hohen Pegel auf den niedrigen Pegel geändert wird, der Zählerwert, der dem Zähler zu diesem Zeitpunkt entspricht, in der zweiten Registergruppe gespeichert wird;
wobei sowohl U als auch V ganze Zahlen sind, U kleiner als V ist, sowohl X als auch Y positive ganze Zahlen sind, X kleiner als 50 ist und Y größer als 50 ist,
wobei das Steuern der Differenzeingangsschaltung mit der logischen Einheit entsprechend dem Ausgabeergebnis der Vergleichseinheit ferner umfasst:
die logische Einheit, ferner umfassend eine Operationskomponente und eine dritte Registergruppe;
die Operationskomponente, die Addition, Subtraktion, Multiplikation und Division bei der Ausgabe der ersten Registergruppe und der zweiten Registergruppe durchführt und den erhaltenen numerischen Wert H in der dritten Registergruppe speichert;
wobei H eine ganze Zahl ist und H größer als oder gleich U und kleiner als oder gleich V ist, und
das Tastverhältnis des ersten internen Signals, das H entspricht, im zweiten voreingestellten Bereich liegt.

## Revendications

1. Circuit d'étalonnage, comprenant :
un circuit d'entrée différentielle (101), configuré pour recevoir un premier signal d'oscillation et un deuxième signal d'oscillation, le premier signal d'oscillation et le deuxième signal d'oscillation ayant une même fréquence et des phases opposées, un rapport cyclique du premier signal d'oscillation et un rapport cyclique du deuxième signal d'oscillation étant dans une première plage prédéfinie, et le circuit d'entrée différentielle (101) étant configuré pour fournir en sortie un premier signal interne et un deuxième signal interne ;
une unité de comparaison (102), connectée à une extrémité de sortie du circuit d'entrée différentielle (101), et configurée pour comparer le rapport cyclique du premier signal interne et/ou le rapport cyclique du deuxième signal interne ; et
une unité logique (103), connectée à l'unité de comparaison (102) et au circuit d'entrée différentielle (101), et configurée pour commander le circuit d'entrée différentielle (101) en fonction d'un résultat de sortie de l'unité de comparaison (102), de telle sorte que le rapport cyclique du premier signal interne et/ou le rapport cyclique du deuxième signal interne atteint une deuxième plage prédéfinie,
dans lequel l'unité de comparaison (102) comprend :
une unité intégrée (112) avec une première extrémité d'entrée et une deuxième extrémité d'entrée, la première extrémité d'entrée étant configurée pour recevoir l'un parmi le premier signal interne ou le deuxième signal interne, et la deuxième extrémité d'entrée étant configurée pour recevoir un autre parmi le deuxième signal interne ou le premier signal interne ; et
un comparateur, connecté à une extrémité de sortie de l'unité intégrée (112),
dans lequel la première extrémité d'entrée de l'unité intégrée (112) est configurée pour recevoir le premier signal interne lorsqu'un signal de drapeau de basculement est à un niveau bas, et recevoir le deuxième signal interne lorsque le signal de drapeau de basculement est à un niveau haut ; et
la deuxième extrémité d'entrée de l'unité intégrée (112) est configurée pour recevoir le deuxième signal interne lorsque le signal de drapeau de basculement est à un niveau bas, et pour recevoir le premier signal interne lorsque le signal de drapeau de basculement est à un niveau haut,
dans lequel l'unité logique (103) comprend :
un compteur (113), configuré pour ajuster le rapport cyclique du premier signal interne et/ou le rapport cyclique du deuxième signal interne ;
un premier groupe de registres (123), configuré pour stocker une première valeur du compteur (113) en fonction de la sortie du comparateur lorsque le signal de drapeau de basculement est à un niveau bas, la première valeur correspondant à un point d'inversion où la sortie de le comparateur saute d'un niveau bas à un niveau haut ; et
un deuxième groupe de registres (133), configuré pour stocker une deuxième valeur du compteur (113) en fonction de la sortie du comparateur lorsque le signal de drapeau de basculement est à un niveau haut, la deuxième valeur correspondant à un point d'inversion où la sortie de le comparateur saute du niveau haut au niveau bas,
dans lequel l'unité logique (103) comprend en outre :
un composant opérationnel (143), connecté au premier groupe de registres (123) et au deuxième groupe de registres (133), et configuré pour effectuer une addition, une soustraction, une multiplication et une division sur la sortie du premier groupe de registres (123) et du deuxième groupe de registres (133); et
un troisième groupe de registres (153), connecté au composant opérationnel (143) et configuré pour stocker un résultat de sortie du composant opérationnel (143),
dans lequel le rapport cyclique du premier signal interne correspondant au résultat de sortie se situe dans la deuxième plage prédéfinie.

2. Circuit d'étalonnage selon la revendication 1, dans lequel l'unité de comparaison (102) est pilotée par une horloge d'échantillonnage, et une fréquence de l'horloge d'échantillonnage est inférieure à une fréquence du premier signal interne et/ou à une fréquence du deuxième signal interne.

3. Circuit d'étalonnage selon la revendication 2, dans lequel le compteur (113) est piloté par une horloge de calculateur, et une fréquence de l'horloge de calculateur est inférieure à la fréquence du premier signal interne et/ou à la fréquence du deuxième signal interne, dans lequel la fréquence de l'horloge d'échantillonnage est la même que la fréquence de l'horloge du calculateur.

4. Circuit d'étalonnage selon la revendication 3, comprenant en outre :
un diviseur de fréquence (104), configuré pour recevoir un signal d'horloge externe, et générer l'horloge d'échantillonnage et l'horloge de calculateur ; et
un quatrième groupe de registres (105), connecté au diviseur de fréquence (104), et adapté pour configurer la fréquence de l'horloge d'échantillonnage et la fréquence de l'horloge du calculateur.

5. Circuit d'étalonnage selon la revendication 1, dans lequel le circuit d'entrée différentielle (101) est en outre configuré pour recevoir un premier signal externe et un deuxième signal externe, et le premier signal externe et le deuxième signal externe ont une même fréquence et des phases opposées,
dans lequel le circuit d'étalonnage comprend en outre : un sélecteur (111), dans lequel le premier signal d'oscillation, le deuxième signal d'oscillation, le premier signal externe et le deuxième signal externe sont connectés au circuit d'entrée différentielle (101) via le sélecteur (111), et en prenant le premier signal d'oscillation et le deuxième signal d'oscillation comme premier signal de paire différentielle et en prenant le premier signal externe et le deuxième signal externe comme deuxième signal de paire différentielle, le sélecteur (111) est configuré pour sélectionner l'un parmi le premier signal de paire différentielle et le deuxième signal de paire différentielle pour être fourni en entrée dans le circuit d'entrée différentielle (101).

6. Circuit d'étalonnage selon la revendication 5, dans lequel une extrémité de commande du sélecteur (111) est configurée pour recevoir un signal d'activation d'étalonnage, lorsque le signal d'activation d'étalonnage est à un niveau bas, le premier signal externe et le deuxième signal externe sont fournis en entrée dans le circuit d'entrée différentielle (101), et lorsque le signal de validation d'étalonnage est à un niveau haut, le premier signal d'oscillation et le deuxième signal d'oscillation sont fournis en entrée dans le circuit d'entrée différentielle (101).

7. Une mémoire, comprenant :
le circuit d'étalonnage selon l'une quelconque des revendications 1 à 6

8. Procédé d'étalonnage, comprenant les étapes consistant à :
recevoir, avec un circuit d'entrée différentielle, un premier signal d'oscillation et un deuxième signal d'oscillation, le premier signal d'oscillation et le deuxième signal d'oscillation ayant la même fréquence et des phases opposées, le rapport cyclique du premier signal d'oscillation et le rapport cyclique du deuxième signal d'oscillation étant dans une première plage prédéfinie, et le circuit d'entrée différentielle délivrant un premier signal interne et un deuxième signal interne (S 1) ;
recevoir, avec une unité de comparaison, le premier signal interne et le deuxième signal interne, et comparer le rapport cyclique du premier signal interne ou le rapport cyclique du deuxième signal interne (S2) ; et
commander, avec une unité logique, le circuit d'entrée différentielle en fonction d'un résultat de sortie de l'unité de comparaison, de telle sorte que le rapport cyclique du premier signal interne et/ou le rapport cyclique du deuxième signal interne atteigne une deuxième plage prédéfinie (S3),
**caractérisé en ce que**
l'étape consistant à recevoir, avec l'unité de comparaison, le premier signal interne et du deuxième signal interne comprend :
lorsqu'un signal de drapeau de basculement est à un niveau bas, l'unité de comparaison compare le rapport cyclique du premier signal interne ; et
lorsque le signal de drapeau de basculement est à un niveau haut, l'unité de comparaison compare le rapport cyclique du deuxième signal interne,
la commande, avec l'unité logique, du circuit d'entrée différentiel en fonction du résultat de sortie de l'unité de comparaison comprenant :
le fait que l'unité logique comprend un compteur, un premier groupe de registres et un deuxième groupe de registres ;
lorsque le signal de drapeau de basculement est à un niveau bas, le compteur comptant de U à V, lorsque la valeur du compteur est U, le rapport cyclique correspondant au premier signal interne étant X%, lorsque la valeur du compteur est V, le rapport cyclique correspondant au premier signal interne étant Y %, et lorsque le résultat de sortie de l'unité de comparaison passe du niveau bas au niveau haut, la valeur du compteur correspondant au compteur à ce moment étant stockée dans le premier groupe de registres ;
lorsque le signal de drapeau de basculement est à un niveau haut, le compteur compte de U à V, lorsque la valeur du compteur est U, le rapport cyclique correspondant au deuxième signal interne étant Y%, lorsque la valeur du compteur est V, le rapport cyclique correspondant au deuxième signal interne étant X%, lorsque le résultat de sortie de l'unité de comparaison est modifié du niveau haut au niveau bas, la valeur du compteur correspondant au compteur à ce moment étant stockée dans le deuxième groupe de registres ;
dans lequel U et V sont des nombres entiers, U est inférieur à V, X et Y sont des nombres entiers positifs, X est inférieur à 50 et Y est supérieur à 50,
dans lequel la commande, au moyen de l'unité logique, du circuit d'entrée différentielle en fonction du résultat de sortie de l'unité de comparaison comprend en outre :
le fait que l'unité logique comprend en outre un composant opérationnel et un troisième groupe de registres ;
le composant opérationnel effectue l'addition, la soustraction, la multiplication et la division à la sortie du premier groupe de registres et du deuxième groupe de registres, et stocke la valeur numérique obtenue H dans le troisième groupe de registres,
dans lequel H est un nombre entier et H est supérieur ou égal à U et inférieur ou égal à V, et
le rapport cyclique du premier signal interne correspondant au H est dans la deuxième plage prédéfinie.
